# EUROPÄISCHE PATENTSCHRIFT

(11) **EP 1 104 129 B1**
(45) Veröffentlichungstag und Bekanntmachung des Hinweises auf die Patenterteilung: **11.07.2007**
(21) Anmeldenummer: 00203913.9
(22) Anmeldetag: 06.11.2000
(51) Int. Cl.: H04J 3/06, H04L 7/033, H04B 7/26, H03L 7/08

(54) **Telekommunikationsgerät mit einer Taktgenerierungseinheit**
Telecommunication device with a clock generating unit
Dispositif de télécommunication avec une unité de géneration d'horloge

(30) Priorität: 13.11.1999 DE 19954696
(43) Veröffentlichungstag der Anmeldung: 30.05.2001
(73) Patentinhaber: Philips Intellectual Property & Standards GmbH, 20099 Hamburg (DE); Koninklijke Philips Electronics N.V., 5621 BA Eindhoven (NL)
(72) Erfinder: Bening, Andreas, 52064 Aachen (DE); Kempf, Peter Dr., 52064 Aachen (DE); Walters, Eckhard, 52064 Aachen (DE)
(74) Vertreter: Pennings, Johannes

(56) Entgegenhaltungen:
- EP-A- 0 432 539
- WO-A-97/21278
- US-A- 5 349 544
- US-A- 5 602 884
- PATENT ABSTRACTS OF JAPAN Bd. 1996, Nr. 04, 30. April 1996 (1996-04-30) & JP 07 336219 A (FUJITSU GENERAL LTD), 22. Dezember 1995 (1995-12-22)

## Beschreibung

Die Erfindung betrifft ein Telekommunikationsgerät mit einer Taktgenerierungseinheit, insbesondere für ein Mobilfunksystem, mit einem Eingang für einen Referenztakt und mit einer elektrischen Schaltungsanordnung, die einen Phasenregelkreis zur Umwandlung des Referenztakts in einen Arbeitstakt aufweist. Die Erfindung betrifft auch eine Taktgenerierungseinheit als solche. Taktgenerierungseinheiten werden üblicherweise in Kommunikationsgeräten für Mobilfunksysteme, beispielsweise in "Handys", eingesetzt, um aus einem Referenztakt, mit dem die Taktgenerierungseinheit beaufschlagt wird, eine Anzahl von Arbeitstakten bereitzustellen. Über die Arbeitstakte werden die unterschiedlichen Funktionseinheiten des Handys betrieben. Dabei werden in Abhängigkeit des Betriebszustands die unterschiedlichen Funktionseinheiten mit unterschiedlichen Arbeitstakten versorgt. Zur Energieeinsparung werden die Funktionseinheiten beispielsweise im Standbybetrieb mit niederfrequenten Arbeitstakten und im Funkbetrieb dagegen mit einem hochfrequenten Arbeitstakt beaufschlagt.

Die wesentliche Komponente der Taktgenerierungseinheit (Clock Generation Unit, CGU) ist der sogenannte Phasenregelkreis (Phase look loop, PLL), der basierend auf dem Referenztakt mehrere Arbeitstakte bereitstellt. Die einzelnen Frequenzen der Arbeitstakte stehen dabei in einem festen Teilerverhältnis zu der Frequenz des Referenztakts. Die Funktionsweise eines programmierbaren Phasenregelkreises ist beispielsweise beschrieben in der US-PS 5,349,544. Der Einsatz eines Phasenregelkreises zur Erzeugung von Arbeitstakten in einem Mobilfunksystem ist beispielsweise bekannt aus der WO 97/21278.

Zur Erzeugung möglichst gleichmäßiger Taktsignale mit möglichst steil ansteigenden und abfallenden Taktflanken sind die Taktgenerierungseinheit und der Phasenregelkreis auf den Referenztakt abgestimmt. Der Referenztakt wird von einem externen Taktgeber mit einer festen Referenztakt-Frequenz bereitgestellt. Die aus der US-PS 5,349,544 und der WO 97/21278 bekannten Phasenregelkreise werden mit einem festen Referenztakt beaufschlagt.

Bei Mobilfunksystemen gibt es unterschiedliche Standards, die auf unterschiedlichen Referenztakten aufbauen. Wesentliche Standard-Mobilfunksysteme sind beispielsweise das GSM-System (Global System for Mobil Communication), das TDMA-System (Time Division Multiple Access) und das CDMA-System (Code Divisional Multiple Access). Diese Systeme haben gemeinsam, dass sie als Multiplexsysteme, insbesondere als Zeitmultiplexsysteme ausgebildet sind, bei denen innerhalb eines für das jeweilige System festgelegten Zeitrahmens mehrere Zeitfenster vorgesehen sind, innerhalb derer unterschiedliche Daten übertragen werden können. Der Zeitrahmen besteht aus mehreren Grundeinheiten, wobei der Grundeinheitentakt von dem Referenztakt des Mobilfunksystems abgeleitet wird. Die Grundeinheitentakte der verschiedenen Systeme unterscheiden sich daher voneinander. Für das GSM-System wird ein Referenztakt von 13 MHz, für das TDMA-System ein Referenztakt von 19,44 MHz und für das CDMA-System ein Referenztakt von 19,66 MHz verwendet.

Aufgrund der unterschiedlichen Referenztakte muss für jedes Mobilfunksystem die Taktgenerierungseinheit speziell ausgelegt werden. Da die Taktgenerierungseinheit in der Regel auf einem Mikrochip oder IC integriert ist, ist eine Umstellung von einem System auf das andere nur durch eine aufwendige Layoutänderung des Chips möglich und damit sehr kostenspielig.

Der vorliegenden Erfindung liegt die Aufgabe zugrunde, ein Telekommunikationsgerät mit einer Taktgenerierungseinheit und ein Verfahren zur Erzeugung eines Arbeitstakts anzugeben, die in den unterschiedlichen Mobilfunksystemen eingesetzt werden können.

Zur Lösung der auf die Taktgenerierungseinheit bezogenen Aufgabe weist diese gemäß der Erfindung einen Eingang für einen Referenztakt sowie eine elektrische Schaltungsanordnung auf, die einen Phasenregelkreis zur Umwandlung des Referenztakts in einen Arbeitstakt umfasst, wobei die Schaltungsanordnung für unterschiedlicher Referenztakte ausgebildete Schaltungsteile aufweist, und wobei einer der Schaltungsteile, der einem speziellen Referenztakt zugeordnet ist, auswählbar ist.

Die Erfindung sieht also vor, das Telekommunikationsgerät bzw. die Taktgenerierungseinheit für den Einsatz in verschiedenen Mobilfunksystemen auszubilden. Dies wird dadurch erreicht, dass in der Taktgenerierungseinheit alternativ zueinander Schaltungsteile angeordnet sind, die für das jeweilige Mobilfunksystem ausgelegt sind. Je nachdem, für welches Mobilfunksystem die Taktgenerierungseinheit eingesetzt werden soll, wird das diesem Mobilfunksystem zugeordnete Schaltungsteil ausgewählt. Über das jeweilige Schaltungsteil wird also ein bestimmter oder mehrere bestimmte Arbeitstakte ausgewählt.

Die Erfindung geht hierbei von Überlegung aus, dass es unter Kostengesichtspunkten wesentlich günstiger ist, innerhalb der Taktgenerierungseinheit unterschiedliche Schaltungsteile vorzusehen, von denen zwar beim Betrieb in einem Kommuniktationsgerät (Handy) lediglich nur ein Schaltungsteil benötigt wird, als für jedes Mobilfunksystem eine eigene Taktgenerierungseinheit bereitzuhalten. Die Taktgenerierungseinheit mit den unterschiedlichen Schaltungsteilen hat insbesondere den Vorteil, dass bei Kapazitätsschwankungen oder Nachfrageschwankungen bei den einzelnen Mobilfunksystemen Mikrochips mit der integrierten Taktgenerierungseinheit ohne großen Kostenaufwand in den anderen Mobilfunksystemen eingesetzt werden können.

In einer bevorzugten Ausführungsform weisen die Schaltungsteile jeweils ein insbesondere im Phasenregelkreis integriertes Teilermodul auf, mit dessen Hilfe der dem jeweiligen Schaltungsteil zugeordnete Referenztakt in mehrere Arbeitstakte umgewandelt wird, wobei die Teilermodule derart ausgestaltet sind, dass zumindest einige der von ihnen erzeugbaren Arbeitstakte annähernd gleich sind.

Hierbei wird von der Überlegung ausgegangen, dass die einzelnen Komponenten in einem Handy auf bestimmte Arbeitstakte abgestimmt sind, und dass es daher äußerst zweckmäßig ist, die Arbeitstakte bereitzustellen, für die die Komponenten ausgelegt sind, und zwar unabhängig davon, in welchem Mobilfunksystem das Handy eingesetzt werden soll. Dies hat den entscheidenden Vorteil, dass lediglich die Taktgenerierungseinheit an das Mobilfunksystem angepasst werden muss, und ansonsten die übrigen Komponenten im wesentlichen unverändert eingesetzt werden können.

Mit Auswahl des Referenztaktes wird gleichzeitig auch das dem Referenztakt zugeordnete Teilermodul als Teil des für den speziellen Referenztakt ausgebildeten Schaltungsteils ausgewählt. Die Teilermodule unterscheiden sich im wesentlichen im Hinblick auf die eingestellten Teilerverhältnisse. Durch die Anordnung von mehreren Teilermodulen ist es ermöglicht, dass zumindest einige der Ausgänge der Taktgenerierungseinheit stets mit den gleichen Arbeitstakten beaufschlagt sind, unabhängig von dem ausgewählten Referenztakt.

In einer alternativen Ausführungsform ist vorzugsweise vorgesehen, dass der Phasenregelkreis feste Teilerverhältnisse unabhängig vom Referenztakt aufweist, und dass über ein Auswahlglied die geeigneten Arbeitstakte ausgewählt werden. Eine solche Auswahl geschieht normalerweise durch Setzen von Registerbits und angeschlossener Gatterlogik. Die Schaltungsteile sind vorzugsweise konfigurierbar, insbesondere programmierbar, und zwar derart, dass die gewünschten Arbeitstakte erzeugt werden. Hierzu wird dem Schaltungsteil beispielsweise eine entsprechende Konfigurationsinformation übermittelt. Insbesondere ist hierbei ein sogenannter "fractional Divider" vorgesehen, über den aus einem nahezu beliebigen Referenztakt ein nahezu beliebiger Arbeitstakt mit gebrochen rationalem Teilverhältnis erzeugbar ist. Ein solcher "fractional Divider" dient insbesondere der Feinabstimmung für die Arbeitstakte.

Vorteilhafterweise weist der Phasenregelkreis eingangsseitig unterschiedliche auf die Referenztakte abgestimmte Sätze von Schaltkomponenten auf, die wahlweise aktivierbar sind, wobei die Schaltkomponenten insbesondere das Einschwingverhalten des Phasenregelkreises bestimmen. Das hat den Vorteil, dass der Phasenregelkreis beim Einschalten sehr rasch und störungsfrei einschwingt, so dass er bereits nach kurzer Zeit zuverlässig arbeitet.

Alternativ hierzu weist der Phasenregelkreis einen speziellen Satz von Schaltkomponenten auf, der zur Verarbeitung mehrerer Referenztakte geeignet ist. Bei den Frequenzen 19,44 und 19,66 MHz wird dies vorzugsweise dadurch erreicht, dass der Satz von Schaltkomponenten auf eine mittlere Frequenz abgestimmt wird. Damit entfällt die Notwendigkeit, mehrere Sätze vorzusehen.

Bevorzugt sind die Schaltungsteile zur Bereitstellung zumindest eines annähernd gleichen Arbeitstakts und insbesondere zur Bereitstellung von fünf annähernd gleichen Arbeitstakten ausgebildet, so dass die der Taktgenerierungseinheit nachgeschalteten Komponenten in verschiedenen Betriebsmodi, d. h. mit verschiedenen Arbeitstakten betrieben werden können.

Die Auswahl, welcher Arbeitstakt herangezogen wird, erfolgt bevorzugt über ein Auswahlregister, das beispielsweise von einem Prozessor angesteuert wird. In dem Auswahlregister sind für verschiedene Betriebsmodi des Handys die für die unterschiedlichen Komponenten geeigneten Arbeitstakte abgelegt. Dies dient insbesondere zur Reduzierung des Energieverbrauchs.

In einer besonders bevorzugten Ausführungsform ist aus den bereitgestellten Arbeitstakten ein Grundeinheitentakt auswählbar, und zwar insbesondere durch eine Sofrwarefunktionalität. Dies hat den Vorteil, dass der Grundeinheitentakt neu festgelegt werden kann. Damit wird die Möglichkeit eröffnet, einen geeigneten Takt als Grundeinheitentakt auszuwählen.

Vorzugsweise erfolgt die Auswahl des speziellen Schaltungsteils vor Inbetriebnahme des Phasenregelkreises, so dass die auf den Referenztakt abgestimmten Schaltungsteile bereits beim Einschalten aktiviert sind, wodurch der Phasenregelkreis zügig und zuverlässig seinen Arbeitsbetrieb aufnimmt.

In einer zweckdienlichen Ausgestaltung wird der dem speziellen Referenztakt zugeordnete Schaltungsteil bereits durch das Layout eines Mikrochips, in dem die Taktgenerierungseinheit integriert ist, (IC-Glied) ausgewählt. Dieser Ausgestaltung liegt die Überlegung zu Grunde, dass bei der Herstellung des Mikrochips zunächst die unterschiedlichen Schaltungsteile vorgesehen werden, und dass die Auswahl in einem späten Verfahrensschritt folgt. Für die Auswahl ist es in der Regel ausreichend, dass die im Mikrochip vorgesehenen Halbleiterbauelemente unterschiedlich geschalten werden. Dadurch ist ermöglicht, dass die Auslegung für unterschiedliche Mobilfunksysteme beim Herstellen in einem späten Verfahrensschritt erfolgt, beispielsweise durch Auswahl bestimmter Masken. Dies ist im Vergleich zu einem komplett neuen Design zum einen wesentlich flexibler in der Herstellung und zum anderen wesentlich kostengünstiger, auch wenn mehrere Schaltungsteile vorgesehen sind, von denen nur einer durch die spezielle Verschaltung in einem späten Herstellungsschritt physikalisch aktiviert wird.

Die Auswahl des Schaltungsteils erfolgt alternativ mit Hilfe eines Auswahlsignals, das bevorzugt über eine Hardware-Komponente, insbesondere über einen Anschlusspin, übermittelt wird. Damit wird in vorteilhafter Weise ermöglicht, die Taktgenerierungseinheit beispielsweise vor ihrem Einbau in ein Handy auf das Mobilfunksystem abzustimmen, für das das Handy eingesetzt werden soll. Da hierzu ein einmaliger Vorgang ausreichend ist, steht der Anschlusspin beim Betrieb des Handys anschließend für andere Funktionalitäten zur Verfügung.

In einer alternativen Ausführung wird die Auswahl vorzugsweise über eine Softwarefunktionalität vorgenommen. Hierzu ist insbesondere ein Register mit einem überschreibbaren Registereintrag vorgesehen, über den die Auswahl des Referenztakts festgelegt ist. Hierdurch ist eine besonders einfache und reversible Auswahl möglich.

Da bei der Auswahl über eine Softwarefunktionalität die Taktgenerierungseinheit zunächst aktiviert werden muss, bevor sie die in ihr abgelegte Auswahl abrufen kann, ist es äußerst zweckdienlich, wenn die Schaltungsanordnung der Taktgenerierungseinheit mit einem separaten langsamen Referenz-Anfangstakt hochgefahren wird. Da die Schaltungsteile für unterschiedliche Referenztakte ausgelegt sind, besteht die Möglichkeit, dass die für die langsamen Referenztakte ausgelegten Schaltungsteile beschädigt werden, wenn sie mit einem hohen Referenztakt beaufschlagt werden. Durch die Inbetriebnahme der Schaltungsanordnung mit einem deutlich geringeren Referenz-Anfangstakt ist eine solche Beschädigung ausgeschlossen. Der Referenz-Anfangstakt wird beispielsweise von einem speziellen Takterzeuger bereitgestellt, der gleichzeitig eine interne Uhr ansteuert. Er liefert bevorzugt eine Taktfrequenz im Kilohertzbereich, insbesondere eine Taktfrequenz von 32 KHz.

Um eine Beschädigung von Schaltungsteilen zu vermeiden, ist bei Inbetriebnahme des Phasenregelkreises bevorzugt regelmäßig der für einen hohen Referenztakt ausgebildete Schaltungsteil ausgewählt. Falls über die Software-Funktionalität letztendlich ein Referenztakt mit geringerer Taktfrequenz ausgewählt ist, so wird nach dem Einschalten auf den für den niedrigeren Referenztakt ausgebildeten Schaltungsteil umgeschaltet.

Vorteilhafterweise ist eine solche Taktgenerierungseinheit Bestandteil einer integrierten Schaltung, die beispielsweise im Rahmen eines Chipsatzes zum Assemblieren von Mobilfunkendgeräten bereitgestellt werden kann.

Zur Lösung der auf das Verfahren bezogenen Aufgabe wird gemäß der Erfindung ein in einer Schaltungsanordnung integrierter Phasenregelkreis eingangsseitig mit einem Referenztakt beaufschlagt, und ausgangsseitig wird von dem Phasenregelkreis ein Arbeitstakt bereitgestellt, wobei die Schaltungsanordnung für unterschiedlicher Referenztakte ausgebildet ist, und wobei die Schaltungsanordnung zumindest einmal auf einen der Referenztakte abgestimmt wird.

Der wesentliche Gesichtspunkt ist hierbei darin zu sehen, dass eine Abstimmung auf einen speziellen Referenztakt erfolgt, d. h. dass spezielle innerhalb der Schaltungsanordnung vorgesehene Schaltungsteile ausgewählt werden, die auf unterschiedliche Referenztakte abgestimmt sind.

Weitere vorteilhafte Ausführungsformen des Verfahrens sind den Unteransprüchen zu entnehmen. Insbesondere sind die im Hinblick auf die Taktgenerierungseinheit ausgeführten bevorzugten Ausführungsformen und besonderen Vorteile sinngemäß auf das Verfahren zu übertragen.

Zur weiteren Erläuterung werden im folgenden Ausführungsbeispiele der Erfindung anhand der Zeichnung näher erläutert. Es zeigen in schematischen Darstellungen:
- Fig. 1: eine Taktgenerierungseinheit mit einem Phasenregelkreis in einem Blockschaltbild,
- Fig. 2: eine alternative Taktgenerierungseinheit in einem Blockschaltbild und
- Fig. 3: ein Blockschaltbild eines Mobilfunksystem-Geräts.

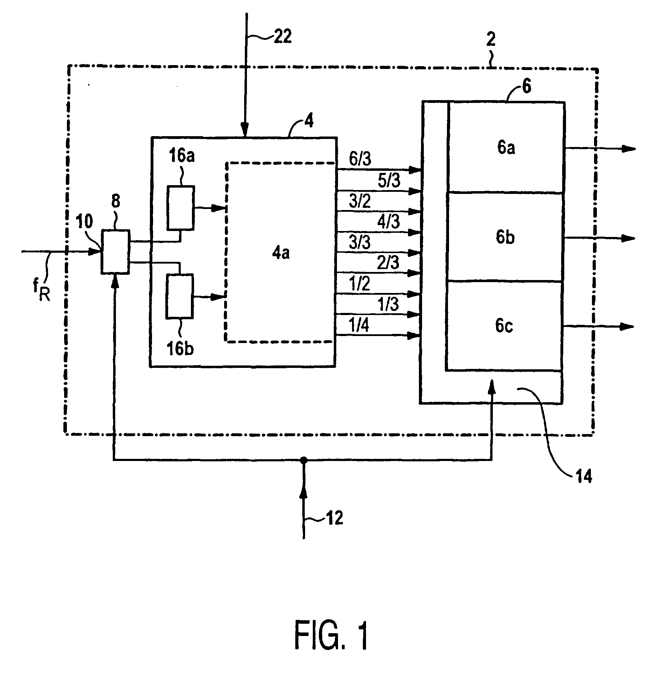

Gemäß Fig. 1 umfasst eine Taktgenerierungseinheit 2 einen Phasenregelkreis 4, ein Auswahlregister 6, ein Schaltelement 8 und einen Eingang 10 für einen Referenztakt fR. Der Phasenregelkreis 4, das Auswahlregister 6 und das Schaltelement 8 sind Bestandteile einer Schaltungsanordnung der Taktgenerierungseinheit 2. Diese ist mit einem Auswahlsignal 12 beaufschlagbar, welches an das Schaltelement 8 und an ein Auswahlglied 14 übermittelt wird, welches insbesondere ein Teil des Auswahlregisters 6 ist.

Über das Auswahlsignal 12 wird festgelegt, für welchen Referenztakt fR die Taktgenerierungseinheit 2 ausgelegt wird. Dies erfolgt gemäß Fig. 1 zum einen dadurch, dass das Schaltelement 8 in Abhängigkeit des Auswahlsignals 12 den Eingang 10 wahlweise mit einem ersten oder mit einem zweiten Satz von Schaltkomponenten 16a, 16b verbindet. Die Sätze 16a,16b sind eingangsseitig im Phasenregelkreis 4 integriert und bestimmen dessen Einschwingverhalten. Sie sind auf unterschiedliche Referenztakte abgestimmt, um bei Auswahl des jeweiligen Referenztakts fR ein möglichst schnelles Einschwingen zu ermöglichen. Der Satz 16a ist beispielsweise auf die Referenzfrequenz 13 MHz für das GSM-System und der Satz 16b ist als spezieller Satz auf etwa 19,5 MHz gemeinsam für das TDMA-System und das CDMA-System abgestimmt. Der spezielle Satz 16b ist derart ausgelegt, dass ein ausreichend gutes Einschwingverhalten des Phasenregelkreises 4 unabhängig von der angelegten Referenzfrequenz fR gewährleistet ist. Für die beiden letztgenannten können auch separate Sätze vorgesehen sein. Durch das Schaltelement 8 wird also jeweils nur ein Satz 16a, bzw. 16b mit dem Referenztakt fR beaufschlagt, der anschließend in einem Teilbereich 4a im Phasenregelkreis 4 weiterverarbeitet wird. Die Sätze 16a, 16b sind speziell auf die Referenztakte fR ausgebildeten Schaltungsteilen zugehörig. Der Teilbereich 4a weist bevorzugt einen sogenannten "fractional divider" auf, über den insbesondere eine Feinabstimmung für die Erzeugung der Arbeitstakte vorgenommen wird. Dabei wird der "fractional Divider" in Abhängigkeit der Referenzfrequenz fR derart konfiguriert, dass exakt die gewünschten Arbeitstakte bereitgestellt werden, egal welche Referenzfrequenz fR ausgewählt wird.

Vom Phasenregelkreis 4 werden mehrere Arbeitstakte ausgangsseitig bereitgestellt, deren Frequenzen in einem festen Teilerverhältnis zu der Frequenz des Referenztakts fR stehen. Dies sind insbesondere die Teilerverhältnisse 6/3, 5/3, 3/2, 4/3, 3/3, 2/3, 1/2, 1/3 und 1/4.

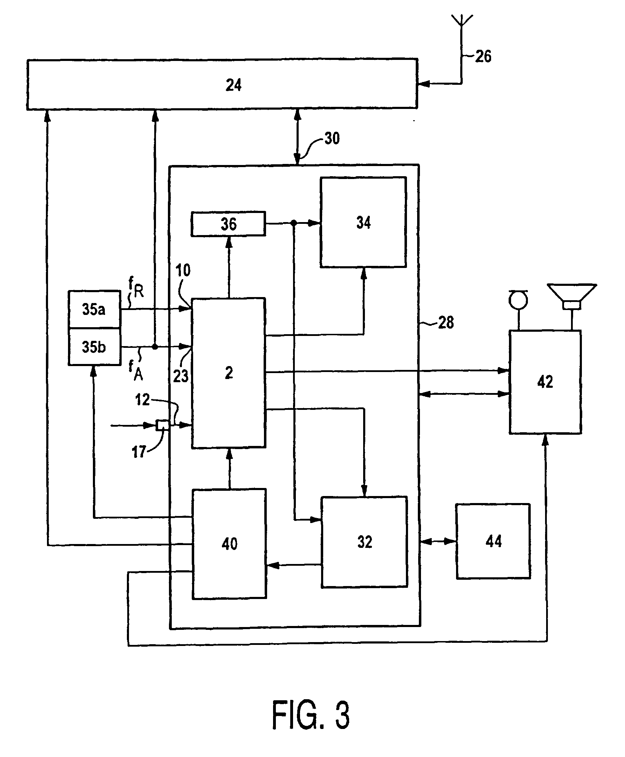

Aus diesen Arbeitstakten wählt das Auswählregister 6 geeignete Arbeitstakte aus. Hierzu ist das Auswahlregister 6 bevorzugt in mehrere Teilregister 6a, 6b, 6c unterteilt, die beispielsweise die Auswahl eines geeigneten Arbeitstaktes für eine Mensch-Maschine-Schnittstelle 42, für verschiedene Prozessoren 32,34 und für eine Zeitbasiseinheit 36 vornehmen (vgl. Fig. 3).

Nach dem Ausführungsbeispiel der Fig. 1 liefert der Phasenregelkreis 4 ausgangsseitig feste Teilerverhältnisse zu dem eingangsseitig angelegten Referenztakt fR. Bei unterschiedlichen Referenztakten fR liegen daher an den einzelnen Ausgängen des Phasenregelkreises 4 mit den festgelegten Teilerverhältnissen unterschiedliche Arbeitstakte an. Bei einem Referenztakt fR von 13 MHz liegt beispielsweise am Ausgang mit einem Teilerverhältnis 6/3 ein Arbeitstakt von 26 MHz an, wohingegen bei einem Referenztakt von 19,44 MHz an dem gleichen Ausgang ein Arbeitstakt mit 38,88 MHz anliegt. Um die der Taktgenerierungseinheit 2 nachgeschalteten Komponenten mit für sie geeignete Arbeitstakte zu versorgen ist das Auswahlglied 14 vorgesehen. Dieses ist beispielsweise als Speicher ausgebildet, in dem die Information abgelegt ist, bei welchem Referenztakt fR welcher Arbeitstakt an welchem Ausgang anliegt. So ist darin beispielsweise abgelegt, dass bei einem Referenztakt fR von 13 MHz der 26 MHz Arbeitstakt über den Ausgang mit dem 6/3 Teilerverhältnis abrufbar ist. Wohingegen bei einem Referenztakt von fR von 19,44 MHz der annähernd gleiche Arbeitstakt mit 25,92 MHz an dem 4/3-Ausgang anliegt. Das Auswahlglied 14 übermittelt diese Information an die Teilregister 6a bis 6c, so dass diese den Zugriff auf den richtigen Ausgang veranlassen, wenn beispielsweise ein 26 MHz Arbeitstakt abgerufen werden soll.

Die unterschiedlichen Teilerverhältnisse des Phasenregelkreises 4 sind dabei auf die Referenztakte fR der unterschiedlichen Mobilfunksysteme derart abgestimmt, dass mehrere der bereitgestellten Arbeitstakte unabhängig vom anliegenden Referenztakt fR einen annähernd gleichen Wert aufweisen. Wie aus der nachstehenden Tabelle beispielhaft zu entnehmen ist, sind für die unterschiedlichen Mobilfunksystem insgesamt fünf etwa gleiche Taktfrequenzen einstellbar. Dies sind die Arbeitstaktfrequenzen 26 MHz, 19,5 MHz, 13 MHz, 6,5 MHz und 4,3 MHz (Hervorhebung durch Fettdruck).

| Teilerverhältnis | GSM fR = 13MHz | TDMA fR = 19,44 MHz | CDMA fR = 19,66 MHz |
|---|---|---|---|
| 6/3 | 26 MHz | 38,88 MHz | 39,36 MHz |
| 5/3 | 21,67 MHz | 32,4 MHz | 32,8 MHz |
| 3/2 | 19,5 MHz | 29,16 MHz | 29,52 MHz |
| 4/3 | 17,33 MHz | 25,92 MHz | 26,24 MHz |
| 3/3 | 13 MHz | 19,44 MHz | 19,68 MHz |
| 2/3 | 8,66 MHz | 12,96 MHz | 13,12 MHz |
| 1/2 | 6,5 MHz | 9,72 MHz | 9,64 MHz |
| 1/3 | 4,33 MHz | 6,48 MHz | 6,56 MHz |
| 1/4 | 3,25 MHz | 4,86 MHz | 4,9 MHz |

Für die Übermittlung des Auswahlsignals 12 an die Schaltanordnung der Taktgenerierungseinheit 2 bieten sich unterschiedliche Möglichkeiten an. Eine besteht darin, das Auswahlsignal 12 über einen Hardware-Anschluss, beispielsweise über einen Anschlusspin 17 (in Fig. 3 dargestellt) zu übermitteln. Dabei wird der Anschlusspin 17 mit einem Auswahlsignal 12 beaufschlagt, welches beispielsweise dazu führt, dass das Schaltelement 8 den Eingang 10 irreversibel mit einem der Sätze von Schaltkomponenten 16a, 16b verbindet. Zugleich wird im als Speicher ausgebildeten Auswahlglied 14 die Information über den Referenztakt fR bevorzugt ebenfalls irreversibel festgeschrieben. Die Taktgenerierungseinheit 2 wird daher durch eine einmalige Auswahl auf einen bestimmten Referenztakt fR abgestimmt. Diese Abstimmung ist nicht zwangsläufig irreversibel. Eine andere, nicht in den Figuren dargestellte Möglichkeit besteht beispielsweise darin, mehrere Anschlusspins vorzusehen, die für den Anschluss von unterschiedlichen Referenztakten fR vorgesehen sind. Je nachdem, welcher der Anschlusspins angeschlossen ist, wird einer der beiden Schaltkomponentensätze 16a bzw. 16 mit dem Referenztakt fR beaufschlagt.

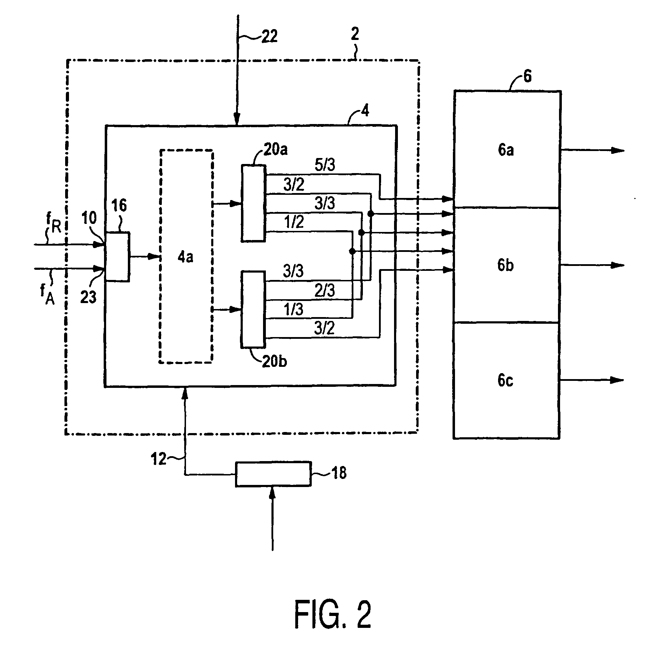

Die Auswahl erfolgt bevorzugt vor der Inbetriebnahme des Phasenregelkreises 4, damit bereits beim Einschalten die richtigen Schaltungsteile ausgewählt sind. Da in einigen Betriebsmodi des Handys, beispielsweise im Standby-Betrieb, die Taktgenerierungseinheit 2 über ein Reset-Signal 22 ausgeschaltet wird, erfolgt die Auswahl des Auswahlsignals vorzugsweise vor der Deaktivierung des Resets.
Alternativ zu der hardwaretechnischen Ausführung ist eine Softwarefunktionalität vorgesehen, über die das Auswahlsignal 12 übermittelt wird. Hierzu ist beispielsweise gemäß Fig. 2 ein Speicher 18 angeordnet, in dem die Information über den ausgewählten Referenztakt abgelegt ist. Diese Information ist insbesondere überschreibbar.

In Fig. 2 ist eine alternative Ausführung der Taktgenerierungseinheit 2 dargestellt. Im Unterschied zu der in Fig. 1 dargestellten Taktgenerierungseinheit 2 ist das Auswahlregister 6 nicht in der Taktgenerierungseinheit 2 integriert. Die unterschiedlichen Sätze von Schaltkomponenten 16a, 16b gemäß Fig. 1 sind durch den Schaltkomponentensatz 16 symbolisiert.

Der Speicher 18 ist nach Fig. 2 außerhalb der Taktgenerierungseinheit 2 angeordnet, kann aber auch ein Bestandteil von ihr sein. Da in dem Speicher 18 die Auswahlinformation abgelegt ist, wird diese von der Taktgenerierungseinheit 2 erst abgerufen, wenn das Handy in Betrieb genommen wird. Um zu verhindern, dass Komponenten mit einer zu hohen Taktfrequenz beaufschlagt werden und Schaden nehmen, ist vorgesehen, die Taktgenerierungseinheit 2 bei Ihrer Inbetriebnahme mit einem Referenz-Anfangstakt fA mit im Vergleich zum Referenztakt fR geringerer Frequenz zu beaufschlagen. Hierzu ist ein weiterer Eingang 23 vorgesehen. Vorzugsweise wird hierzu eine Taktfrequenz im Kilohertzbereich ausgewählt, die für eine interne Uhr im Handy vorgesehen ist. Unmittelbar nach dem Einschalten wird die Auswahlinformation aus dem Speicher 18 abgerufen und das Auswahlsignal 12 bewirkt die Auswahl der speziellen Schaltungsteile die dem ausgewählten Referenztakt fR entsprechen. Im Ausführungsbeispiel nach der Fig. 2 umfassen diese speziellen Schaltungsteile die Teilermodule 20a, 20b.

Alternativ ist eine Grundeinstellung vorgesehen, bei der jeweils die für eine hohen Referenztakt fR ausgelegten Schaltungsteile bei Inbetriebnahme der Taktgenerierungseinheit 2 aktiviert sind. Ist ein geringerer Referenztakt fR ausgewählt, so werden erst nach Inbetriebnahme die diesem zugeordneten Schaltungsteile aktiviert. Das Auswahlsignal 12 wird an den Teilbereich 4a des Phasenregelkreises 4 übermittelt, der zwischen dem Schaltkomponentensatz 16 und den Teilermodulen 20a, 20b angeordnet ist.

Je nach übermittelter Auswahlinformation 12 wird eines der beiden Teilermodule 20a, 20b ausgewählt. Diese sind hinsichtlich ihrer Teilerverhältnisse derart ausgelegt, dass sie zumindest einige annähernd gleiche Arbeitstakte bereitstellen. Die Ausgänge der Teilermodule 20a, 20b, die die gleichen Arbeitstakte bereitstellen, sind miteinander verbunden und können ausgangsseitig an der Taktgenerierungseinheit 2 abgerufen werden. Zumindest an einigen Ausgängen der Taktgenerierungseinheit 2 liegen daher unabhängig von der Eingangs-Referenzfrequenz die gleichen Arbeitstakte an. Im Ausführungsbeispiel nach Fig. 2 wird angenommen, dass das Teilermodul 20a für den 13-MHz-Arbeitstakt ausgelegt ist und beispielsweise die Teilerverhältnisse 5/3, 3/2, 3/3 und 1/5 aufweist. Demgegenüber weist das Teilermodul 20b die Teilerverhältnisse 3/3, 2/3, 1/3 und 3/2 auf und ist für einen Referenztakt von etwa 19,5 MHz ausgebildet, so dass von den beiden Teilermodulen 20a, 20b drei etwa annähernd gleiche Taktfrequenzen bereitgestellt werden. Die von der Taktgenerierungseinheit 2 bereitgestellten Arbeitstakte werden an das Auswahlregister 6 weitergeleitet, das im Gegensatz zu der Fig. 1 nunmehr lediglich die drei Teilregister 6a, 6b, 6c aufweist. Da an zumindest einigen Ausgängen der Taktgenerierungseinheit 2 unabhängig von der getroffenen Auswahl die gleichen Arbeitstakte anliegen, ist ein Auswahlglied 14 im Ausführungsbeispiel nach der Fig. 2 nicht zwingend notwendig.

Im folgenden wird anhand der Fig. 3 das Zusammenwirken von wesentlichen Komponenten in einem Mobilfunksystem-Kommunikationsgerät, beispielsweise in einem Handy, kurz erläutert. Dieses umfasst eine Hochfrequenzeinheit 24, die über eine Antenne 26 die Schnittstelle zur Atmosphäre bildet. Die Hochfrequenzeinheit 24 ist mit dem Referenztakt fR beaufschlagt und ist mit einem Mikrochip 28 verbunden, wie durch den Doppelpfeil 30 dargestellt ist. Die Verbindung erfolgt über einen Digital/Analog-Konverter, der die analogen Signale der Hochfrequenzeinheit 24 in digitale Signale für den Mikrochip 28 aufbereitet und umgekehrt. Auf dem Mikrochip 28 ist als Schaltanordnung ein sogenannter Basisbandschaltkreis integriert. Er weist als zentrales Element die Taktgenerierungseinheit 2 auf, die einen Systemsteuerungsprozessor 32 und einen Basisbandprozessor 34 mit einem geeigneten Arbeitstakt versorgt. Der Basisbandprozessor 34 ist beispielsweise für die Sprachbearbeitung zuständig, wohingegen der Systemsteuerungsprozessor 32 die internen Abläufe innerhalb des Handys steuert.

Die Taktgenerierungseinheit 2 übermittelt an eine Zeitbasiseinheit 36 einen speziellen Arbeitstakt, den sogenannten Grundeinheitentakt. Für das GSM-System wird die Zeitbasiseinheit 36 hierzu vorzugsweise mit einem Arbeitstakt mit einer Frequenz von 4,33 MHz beaufschlagt. Die Zeitbasiseinheit 36 liefert den genau definierten Zeitrahmen des entsprechenden Mobilfunksystems. Dieser Zeitrahmen ist in mehrere Grundeinheiten aufgeteilt, die die Zeitbasiseinheit 36 den beiden Prozessoren 32,34 in Form von Grundeinheitentakte übermittelt.

Die Taktgenerierungseinheit 2 ist mit ihrem Eingang 10 an einem Taktgenerator 35a für den Referenztakt fR und mit einem weiteren Eingang 23 an einen Taktgenerator 35b für den Referenz-Anfangstakt fA angeschlossen. Die Auswahl des speziellen Referenztakts fR erfolgt über den Anschlusspin 17 am Mikrochip 28, über den das Auswahlsignal 12 an die Taktgenerierungseinheit 2 übermittelt wird.

Über den Anschlusspin 16 werden bevorzugt auch Programmierungsschritte an der programmierbaren Taktgenerierungseinheit 2 vorgenommen. Beispielsweise wird der für die Zeitbasiseinheit 36 bereitgestellte Grundeinheitentakt mit Hilfe einer entsprechenden Programmanweisung eingestellt. Die für die unterschiedlichen Referenztakte fR ausgebildete Taktgenerierungseinheit 2 weist im wesentlichen den Vorteil auf, dass sie in einfacher Weise in bestehende Basisbandschaltkreise für unterschiedliche Mobilfunksysteme integriert werden kann. Es ist nicht notwendig, die übrigen Komponenten des Basisbandschaltkreises an die Taktgenerierungseinheit 2 anzupassen, da diese unabhängig vom Referenztakt fR geeignete Arbeitstakte zur Verfügung stellt.

Zur Steuerung der internen Funktionsabläufe ist der Systemsteuerungsprozessor 32 insbesondere mit einer Leistungssteuereinheit (Power-Management) 40 verbunden. Anhand der aktuellen Betriebsanforderungen legt der Systemsteuerungsprozessor 32 fest, welcher Arbeitstakt für welche Komponente ausgewählt wird. Diese Information wird über die Leistungssteuereinheit 40 an die Taktgenerierungseinheit 2 weitergeleitet, die dann die entsprechenden Arbeitstakte an die weiteren Komponenten liefert. Dies erfolgt beispielsweise über das in den Figuren 1 und 2 dargestellte Auswahlregister 6. Zugleich werden über die Leistungssteuereinheit 40 die Hochfrequenzeinheit 24, der Taktgenerator 35a für den Referenztakt fR sowie eine Mensch-Maschineschnittstelle 42 in einen geeigneten Betriebsmodus, beispielsweise in einen Standby-Modus, geschaltet. Zur Steuerung der internen Funktionsabläufe greift der auf dem Mikrochip 28 integrierte Basisbandschaltkreis bevorzugt auf in einem Datenspeicher 44 abgelegte Informationen zurück.

## Patentansprüche

1. Taktgenerierungseinheit (2), insbesondere für ein Mobilfunksystem, mit einem Eingang (10) für einen Referenztakt (f_{R}), mit einer elektrischen Schaltungsanordnung umfassend einen Phasenregelkreis (4) zur Umwandlung des Referenztakts (f_{R}) in einen Arbeitstakt, **dadurch gekennzeichnet, dass** die Schaltungsanordnung für unterschiedliche Referenztakte (f_{R}) ausgebildete Schaltungsteile (16a, 16b; 20a, 20b) aufweist, und dass einer der Schaltungsteile (16a, 20a) auswählbar ist.

2. Taktgenerierungseinheit (2) nach Anspruch 1, **dadurch gekennzeichnet,dass** die Schaltungsteile (16a, 16b; 20a, 20b) jeweils ein insbesondere im Phasenregelkreis (4) integriertes Teilermodul (20a, 20b) zur Umwandlung des dem Schaltungsteil (16a, 20a; 16b, 20b) zugeordneten Referenztakts (f_{R}) in mehrere Arbeitstakte aufweisen, wobei Teilermodule (20a, 20b) Teilerverhältnisse aufweisen, so dass einige der von ihnen erzeugbaren Arbeitstakte im Wesentlichen gleich sind.

3. Taktgenerierungseinheit (2) nach Anspruch 1, **dadurch gekennzeichnet, dass** der Phasenregelkreis (4) unabhängig vom ausgewählten Schaltungsteil (16a, 16b; 20a, 20b) zur Umwandlung des Referenztakts (f_{R}) in mehrere Arbeitstakte feste Teilerverhältnisse aufweist, und dass ein Auswahlglied (14) vorgesehen ist, das in Abhängigkeit des ausgewählten Referenztakts (f_{R}) bestimmte vom Phasenregelkreis (4) erzeugte Arbeitstakte auswählt.

4. Taktgenerierungseinheit (2) nach einem der vorhergehenden Ansprüche, **dadurch gekennzeichnet, dass** die Schaltungsteile (16a, 16; 20a, 20b) in Abhängigkeit des Referenztakts (f_{R}) konfigurierbar sind.

5. Taktgenerierungseinheit (2) nach einem der vorhergehenden Ansprüche, **dadurch gekennzeichnet, dass** der Phasenregelkreis (4) eingangsseitig unterschiedliche auf die Referenztakte (f_{R}) abgestimmte Sätze von Schaltkomponenten (16a, 16b) aufweist, die sein Einschwingverhalten bestimmen und wahlweise aktivierbar sind.

6. Taktgenerierungseinheit (2) nach einem der Ansprüche 1 bis 5, **dadurch gekennzeichnet, dass** der Phasenregelkreis (4) eingangsseitig einen speziellen Satz von Schaltkomponenten (16) aufweist, der sein Einschwingverhalten bestimmt und zur Verarbeitung mehrerer Referenztakte (f_{R}) geeignet ist.

7. Taktgenerierungseinheit (2) nach einem der vorhergehenden Ansprüche, **dadurch gekennzeichnet, dass** die Schaltungsteile (16a, 16b; 20a, 20b) zur Bereitstellung zumindest eines gleichen Arbeitstakts, und insbesondere zur Bereitstellung von fünf gleichen Arbeitstakten ausgebildet sind.

8. Taktgenerierungseinheit nach einem der vorhergehenden Ansprüche, **dadurch gekennzeichnet, dass** die bereitgestellten Arbeitstakte über ein Auswahlregister (6) auswählbar sind.

9. Taktgenerierungseinheit (2) nach einem der vorhergehenden Ansprüche, **dadurch gekennzeichnet, dass** aus den Arbeitstakten ein Grundeinheitentakt insbesondere durch eine programmierbare Software-Funktionalität auswählbar ist.

10. Taktgenerierungseinheit (2) nach einem der vorhergehenden Ansprüche, **dadurch gekennzeichnet, dass** die Schaltungsanordnung derart ausgelegt ist, dass die Auswahl des dem speziellen Referenztakt (f_{R}) zugeordneten Schaltungsteils (16a, 20a) vor Inbetriebnahme des Phasenregelkreises (4) vorgenommen wird.

11. Taktgenerierungseinheit (2) nach einem der vorhergehenden Ansprüche, **dadurch gekennzeichnet, dass** sie auf einem Mikrochip (28) integriert ist, und dass einer der Schaltungsteile (16a, 16b; 20a, 20b) durch das Layout des Mikrochips (28) ausgewählt ist.

12. Taktgenerierungseinheit (2) nach einem der vorhergehenden Ansprüche, **dadurch gekennzeichnet, dass** zur Auswahl des dem speziellen Referenztakt (f_{R}) zugeordneten Schaltungsteils (16a, 20a) ein Anschlusspin (17) zur Übermittlung eines Auswahlsignals vorgesehen ist.

13. Taktgenerierungseinheit (2) nach einem der vorhergehenden Ansprüche, **dadurch gekennzeichnet, dass** zur Auswahl des dem speziellen Referenztakt (f_{R}) zugeordneten Schaltungsteils eine in die Schaltungsanordnung integrierte Software-Funktionalität vorgesehen ist.

14. Taktgenerierungseinheit (2) nach Anspruch 13, **dadurch gekennzeichnet, dass** ein Register (6) vorgesehen ist, das einen überschreibbaren Registereintrag aufweist, über den die Auswahl des Referenztakts (f_{R}) festgelegt ist.

15. Taktgenerierungseinheit (2) nach Anspruch 13 oder 14, **dadurch gekennzeichnet, dass** die Schaltungsanordnung einen weiteren Eingang (38) für einen langsamen Referenz-Anfangstakt (f_{A}) aufweist, mit dem der Phasenregelkreis (4) bei seiner Inbetriebnahme verbunden ist.

16. Taktgenerierungseinheit (2) nach Anspruch 13 oder 14, **dadurch gekennzeichnet, dass** bei Inbetriebnahme des Phasenregelkreises (4) der für einen hohen Referenztakt (f_{R}) ausgebildete Schaltungsteil (16b, 20b) ausgewählt ist.

17. Telekommunikationsgerät mit einer Taktgenerierungseinheit (2) nach einem der vorhergehenden Ansprüche.

18. Verfahren zur Erzeugung eines Arbeitstakts, insbesondere für ein Mobilfunksystem, bei dem ein in einer Schaltungsanordnung integrierter Phasenregelkreis (4) eingangsseitig mit einem Referenztakt (f_{R}) beaufschlagt wird und ausgangsseitig den Arbeitstakt bereitstellt, **dadurch gekennzeichnet, dass** die Schaltungsanordnung für unterschiedliche Referenztakte (f_{R}) ausgebildet ist, und die Schaltungsanordnung zumindest einmal auf einen der Referenztakte (f_{R}) abgestimmt wird.

19. Verfahren nach Anspruch 18, **dadurch gekennzeichnet, dass** die Abstimmung vor der Inbetriebnahme des Phasenregelkreises (4) erfolgt.

20. Verfahren nach Anspruch 18 oder 19, **dadurch gekennzeichnet, dass** der Schaltungsanordnung über einen Anschlusspin (17) ein Auswahlsignal übermittelt wird, anhand dessen die Abstimmung vorgenommen wird.

21. Verfahren nach einem der Ansprüche 18 bis 20, **dadurch gekennzeichnet, dass** in einem Auswahlregister (6) zumindest einmalig eine Auswahlinformation über den Referenztakt (f_{R}) abgelegt wird, anhand derer die Abstimmung vorgenommen wird.

22. Verfahren nach einem der Ansprüche 18 bis 21, **dadurch gekennzeichnet, dass** der Phasenregelkreis (4) zumindest bei seiner Inbetriebnahme mit einem langsamen Referenz-Anfangstakt (f_{A}) beaufschlagt wird, dass anschließend die Abstimmung auf den Referenztakt (f_{R}) erfolgt, und der Phasenregelkreis (4) mit dem Referenztakt (f_{R}) beaufschlagt wird.

## Claims

1. A clock generation unit (2) for a mobile radio system, having an input (10) for a reference clock (f_{R}), including an electrical circuit arrangement which has a phase-locked loop (4) for converting the reference clock (f_{R}) into a working clock, **characterized in that** the circuit arrangement has circuit portions (16a, 16b; 20a, 20b) provided for different reference clocks (f_{R}) and **in that** one of the circuit portions (16a, 16b; 20a, 20b) can be selected.

2. A clock generation unit (2) as claimed in claim 1, **characterized in that** the circuit portions (16a, 16b; 20a, 20b) include each a divider module (20a, 20b) integrated especially with the phase-locked loop (4) for converting the reference clock (f_{R}) assigned to the circuit portion (16a, 20a; 16b, 20b) into a plurality of working clocks, which divider modules (20a, 20b) have divider ratios so that several of the working clocks that can be generated by them are substantially the same.

3. A clock generation unit (2) as claimed in claim 1, **characterized in that** the phase-locked loop (4) has fixed divider ratios irrespective of the selected circuit portion (16, 16b; 20a, 20b) for converting the reference clock (f_{R}) into a plurality of working clocks, and **in that** a selecting element (14) is provided which selects certain working clocks generated by the phase-locked loop (4) in dependence on the selected reference clock (f_{R}).

4. A clock generation unit (2) as claimed in one of the preceding claims, **characterized in that** the circuit portions (16a, 16b; 20a, 20b) can be configured in dependence on the reference clock (f_{R}).

5. A clock generation unit (2) as claimed in any one of the preceding claims, **characterized in that** the phase-locked loop (4) has on the input side sets of different circuit portions (16a, 16b) tuned to the reference clocks (f_{R}), which sets of different circuit portions determine the locking pattern of the phase-locked loop (4) and can be activated selectively.

6. A clock generation unit (2) as claimed in any one of the claims 1 to 5, **characterized in that** the phase-locked loop (4) has on the input side a special set of circuit portions (16) which set of circuit portions determines the locking pattern of the phase-locked loop (4) and is suitable for processing a plurality of reference clocks (f_{R}).

7. A clock generation unit (2) as claimed in any one of the preceding claims, **characterized in that** the circuit portions (16a, 16b; 20a, 20b) are arranged for providing at least a substantially same working clock and, more particularly, for providing five substantially equal working clocks.

8. A clock generation unit (2) as claimed in any one of the preceding claims, **characterized in that** the provided working clocks can be selected via a selection register (6).

9. A clock generation unit (2) as claimed in one of the preceding claims, **characterized in that** from the working clocks can be selected a basic unit clock more particularly via a programmable software functionality.

10. A clock generation unit (2) as claimed in any one of the preceding claims, **characterized in that** the circuit arrangement is designed so that the selection of the circuit portions (16a, 20a) assigned to the special reference clock (f_{R}) is made before the phase-locked loop (4) is taken into operation.

11. A clock generation unit (2) as claimed in any one of the preceding claims, **characterized in that** the clock generation unit (2) is integrated with the microchip (28) and **in that** one of the circuit portions (16a, 16b; 20a, 20b) is selected by the layout of the microchip (28).

12. A clock generation unit (2) as claimed in any one of the preceding claims, **characterized in that** for selecting the circuit portion (16a, 20a) assigned to the special reference clock (f_{R}) a connecting pin (17) is provided for transmitting a selection signal.

13. A clock generation unit (2) as claimed in one of the preceding claims, **characterized in that** for selecting the circuit portion assigned to the special reference clock (f_{R}) a software functionality integrated with the circuit arrangement is provided.

14. A clock generation unit (2) as claimed in claim 13, **characterized in that** a register (6) is provided which has a rewritable register entry via which the selection of the reference clock (f_{R}) is fixed.

15. A clock generation unit (2) as claimed in claim 13 or 14, **characterized in that** the circuit arrangement has a further input (38) for a slow reference start clock (f_{A}) to which the phase-locked loop (4) is connected when it is taken into operation.

16. A clock generation unit (2) as claimed in claim 13 or 14, **characterized in that** the circuit portion (16b, 20b) arranged for the high reference clock (f_{R}) is selected when the phase-locked loop (4) is taken into operation.

17. A telecommunication device with a clock generation unit (2) as claimed in any one of the preceding claims.

18. A method of generating a working clock, more particularly for a mobile radio system, in which a phase-locked loop (4) integrated with a circuit arrangement is supplied with a reference clock (f_{R}) on the input side and provides the working clock on the output side, **characterized in that** the circuit arrangement is designed for different reference clocks (f_{R}) and **in that** the circuit arrangement is tuned at least once to one of the reference clocks (f_{R}).

19. A method as claimed in claim 18, **characterized in that** the tuning is effected before the phase-locked loop (4) is put into operation.

20. A method as claimed in claim 18 or 19, **characterized in that** the circuit arrangement is supplied with a selection signal via a connecting pin (17), on account of which selection signal a tuning is effected.

21. A method as claimed in one of the claims 18 to 20, **characterized in that** selection information about the reference clock (f_{R}) is stored at least once in a selection register (6) on the basis of which information the tuning is effected.

22. A method as claimed in any one of the claims 18 to 21, **characterized in that** the phase-locked loop (4) is supplied with a slow reference start clock (f_{A}) at least when taken into operation, **in that** thereafter the tuning to the reference clock (f_{R}) is effected and the phase-locked loop (4) is supplied with the reference clock (f_{R}).

## Revendications

1. Unité de génération d'horloge (2), destinée en particulier à un système de radiocommunication mobile, avec une entrée (10) pour une horloge de référence (f_{R}), avec un agencement de circuit électrique comprenant un circuit de régulation de phase (4) destiné à convertir l'horloge de référence (f_{R}) en une horloge de travail, **caractérisée en ce que** l'agencement de circuit présente des parties de circuit (16a, 16b; 20a, 20b) formées pour différentes horloges de référence (f_{R}), et **en ce qu'**une des parties de circuit (16a, 20a) peut être sélectionnée.

2. Unité de génération d'horloge (2) selon la revendication 1, **caractérisée en ce que** les parties de circuit (16a, 16b; 20a, 20b) présentent chacune un module diviseur (20a, 20b), intégré en particulier dans le circuit de régulation de phase (4), destiné à convertir l'horloge de référence (f_{R}) associée à la partie de circuit (16a, 20a; 16b, 20b) en plusieurs horloges de travail, dans laquelle des modules diviseurs (20a, 20b) présentent des rapports de division tels que certaines des horloges de travail pouvant être générées par ces modules sont substantiellement identiques.

3. Unité de génération d'horloge (2) selon la revendication 1, **caractérisée en ce que** le circuit de régulation de phase (4), indépendamment de la partie de circuit (16a, 16b; 20a, 20b) sélectionnée, destinée à la conversion de l'horloge de référence (f_{R}) en plusieurs horloges de travail, présente des rapports de division fixes, et **en ce qu'**il est prévu un élément de sélection (14) qui, en fonction de l'horloge de référence (f_{R}) sélectionnée, sélectionne certaines horloges de travail générées par le circuit de régulation de phase (4).

4. Unité de génération d'horloge (2) selon l'une quelconque des revendications précédentes, **caractérisée en ce que** les parties de circuit (16a, 16b; 20a, 20b) peuvent être configurées en fonction de l'horloge de référence (f_{R}).

5. Unité de génération d'horloge (2) selon l'une quelconque des revendications précédentes, **caractérisée en ce que** le circuit de régulation de phase (4) présente en entrée différents ensembles de composants de commutation (16a, 16b) accordés sur les horloges de référence (f_{R}) qui déterminent son comportement en régime transitoire et sont activables de manière facultative.

6. Unité de génération d'horloge (2) selon l'une des revendications 1 à 5, **caractérisée en ce que** le circuit de régulation de phase (4) présente en entrée un ensemble spécial de composants de commutation (16) qui détermine son comportement en régime transitoire et convient pour traiter plusieurs horloges de référence (f_{R}).

7. Unité de génération d'horloge (2) selon l'une quelconque des revendications précédentes, **caractérisée en ce que** les parties de circuit (16a, 16b; 20a, 20b) sont formées pour mettre à disposition au moins une horloge de travail identique, et en particulier pour mettre à disposition cinq horloges de travail identiques.

8. Unité de génération d'horloge selon l'une quelconque des revendications précédentes, **caractérisée en ce que** les horloges de travail mises à disposition peuvent être sélectionnées par le biais d'un registre de sélection (6).

9. Unité de génération d'horloge (2) selon l'une quelconque des revendications précédentes, **caractérisée en ce qu'**une horloge d'unité de base peut être sélectionnée parmi les horloges de travail en particulier par une fonctionnalité logicielle programmable.

10. Unité de génération d'horloge (2) selon l'une quelconque des revendications précédentes, **caractérisée en ce que** l'agencement de circuit est conçu de manière telle que la sélection de la partie de circuit (16a, 20a) associée à l'horloge de référence spéciale (f_{R}) est réalisée avant la mise en service du circuit de régulation de phase (4).

11. Unité de génération d'horloge (2) selon l'une quelconque des revendications précédentes, **caractérisée en ce qu'**elle est intégrée sur une puce électronique (28) et qu'une des parties de circuit (16a, 16b; 20a, 20b) peut être sélectionnée via la topologie de la puce électronique (28).

12. Unité de génération d'horloge (2) selon l'une quelconque des revendications précédentes, **caractérisée en ce que**, pour la sélection de la partie de circuit (16a, 20a) associée à l'horloge de référence spéciale (f_{R}), il est prévu une broche de connexion (17) destinée à transmettre un signal de sélection.

13. Unité de génération d'horloge (2) selon l'une quelconque des revendications précédentes, **caractérisée en ce que**, pour la sélection de la partie de circuit associée à l'horloge de référence spéciale (f_{R}), il est prévu une fonctionnalité logicielle programmable intégrée dans l'agencement de circuit.

14. Unité de génération d'horloge (2) selon la revendication 13, **caractérisée en ce qu'**il est prévu un registre (6) qui présente un enregistrement modifiable par le biais duquel est déterminée la sélection de l'horloge de référence (f_{R}).

15. Unité de génération d'horloge (2) selon la revendication 13 ou 14, **caractérisée en ce que** l'agencement de circuit présente une autre entrée (38) pour une fréquence de référence initiale lente (f_{A}) à laquelle est relié le circuit de régulation de phase (4) lors de sa mise en service.

16. Unité de génération d'horloge (2) selon la revendication 13 ou 14, **caractérisée en ce que** la partie de circuit (16b, 20b) formée pour une horloge de référence (f_{R}) élevée, est sélectionnée lors de la mise en service du circuit de régulation de phase (4).

17. Dispositif de télécommunication avec une unité de génération d'horloge (2) selon l'une quelconque des revendications précédentes.

18. Procédé destiné à générer une horloge de travail, en particulier pour un système de radiocommunication mobile, dans lequel un circuit de régulation de phase (4), intégré dans un agencement de circuit, reçoit en entrée une horloge de référence (f_{R}) et met à disposition en sortie l'horloge de travail, **caractérisé en ce que** l'agencement de circuit est formé pour différentes horloges de référence (f_{R}) et **en ce que** l'agencement de circuit est accordé au moins une fois sur une des horloges de référence (f_{R}).

19. Procédé selon la revendication 18, **caractérisé en ce que** l'accord a lieu avant la mise en service du circuit de régulation de phase (4).

20. Procédé selon la revendication 18 ou 19, **caractérisé en ce qu'**un signal de sélection, à l'aide duquel est réalisé l'accord, est transmis à l'agencement de circuit par le biais d'une broche de connexion (17).

21. Procédé selon l'une des revendications 18 à 20, **caractérisé en ce qu'**une information de sélection sur l'horloge de référence (f_{R}), à l'aide de laquelle est réalisé l'accord, est placée au moins une fois dans un registre de sélection (6).

22. Procédé selon l'une des revendications 18 à 21, **caractérisé en ce que** le circuit de régulation de phase (4) reçoit lors de sa mise en service une horloge de référence initiale lente (f_{A}) au moins lors de sa mise en service, **en ce que** l'accord sur l'horloge de référence (f_{R}) a lieu ensuite et **en ce que** le circuit de régulation de phase (4) reçoit l'horloge de référence (f_{R}).
